**Europäisches Patentamt**

**European Patent Office**

**Office européen des brevets**

(19)

(11) Numéro de publication: **0 089 898**
**B1**

(12)

# FASCICULE DE BREVET EUROPÉEN

(45) Date de publication du fascicule du brevet:
15.10.86

(51) Int. Cl.⁴: **H 01 L 23/56**, H 01 L 23/04

(21) Numéro de dépôt: **83400588.6**

(22) Date de dépôt: **22.03.83**

(54) **Module préadapté pour diode hyperfréquence, et procédé de réalisation de la connexion de polarisation de la diode.**

(30) Priorité: **23.03.82  FR 8204920**

(43) Date de publication de la demande:
**28.09.83 Bulletin 83/39**

(45) Mention de la délivrance du brevet:
**15.10.86 Bulletin 86/42**

(84) Etats contractants désignés:
**DE GB NL**

(56) Documents cité:
**FR-A-2 284 195**
**US-A-3 974 518**

**NACHRICHTEN ELEKTRONIK, vol. 33, no. 4, avril 1979, HEIDELBERG (DE), "Millimeterwellen-Halbleiter und Systeme Teil 2", pages 118-123**
**POEE JOURNAL, vol. 72, no. 4, janvier 1980, LONDRES (GB), M. PILGRIM et al.: "An IMPATT diode amplifier for 11 GHz digital radio-relay systems", pages 220-227**

(73) Titulaire: **THOMSON- CSF, 173, Boulevard Haussmann, F-75379 Paris Cedex 08 (FR)**

(72) Inventeur: **Heitzmann, Michel, THOMSON- CSF SCPI 173, bld Haussmann, F-75379 Paris Cedex 08 (FR)**
Inventeur: **Boudot, Marianne, THOMSON- CSF SCPI 173, bld Haussmann, F-75379 Paris Cedex 08 (FR)**

(74) Mandataire: **Taboureau, James, THOMSON- CSF SCPI 19, avenue de Messine, F-75008 Paris (FR)**

## Description

La présente invention concerne un procédé de montage de diode hyperfréquence en vue de réaliser un module préadapté, par utilisation des dimensions du boîtier d'encapsulation de la diode. Le type de montage selon l'invention s'applique aux diodes à avalanche, Gunn, Schottky et autres telles que varactors, varicap. L'objet de l'invention est d'encapsuler une diode dans un boîtier tel que l'on réalise un module préadapté, c'est-à-dire un module permettant d'adapter l'impédance faible de la diode à l'impédance élevée du milieu environnant, généralement l'air. L'encapsulation est faite avec un anneau de diélectrique mince, le quartz convenant particulièrement bien, donnant une faible capacité parasite, et une connexion de type faux beam-lead afin de minimiser l'inductance parasite. La forme du beam-lead permet également de réduire la capacité parasite.

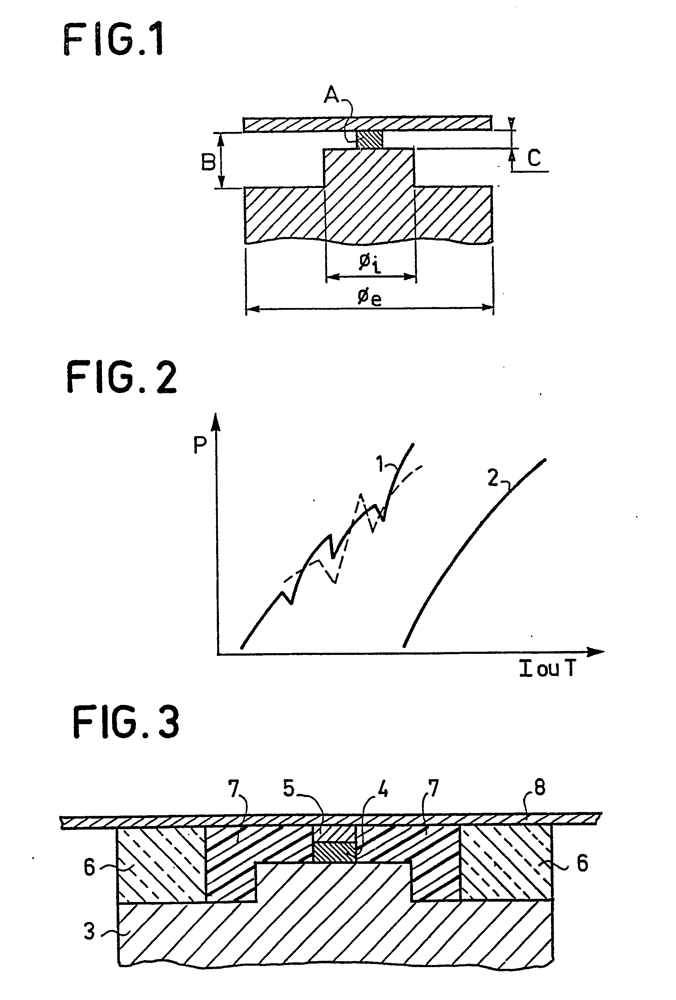

L'adaptation d'impédance est nécessaire en hyperfréquence, par exemple dans la bande 94 GHz, pour une diode qui doit rayonner dans l'espace qui l'entoure. Cette adaptation est particulièrement intéressante sous une forme radiale car elle peut être obtenue grâce à un boîtier ad hoc. Au niveau de la pastille de semi-conducteur, une diode dans le cas présent, l'impédance que présente celle-ci est du type R + jX, dans lequel R représente la partie réelle de la résistance de la diode et X la partie imaginaire de cette résistance, j étant égal par définition à $j^2 = -1$ et est représentatif des imaginaires. R est négatif pour une diode à avalanche ou une diode Gunn, et positif pour une diode Schottky ou d'un autre type. La figure 1 aidera à mieux comprendre l'importance de l'adaptation d'impédance pour l'encapsulation d'une diode.

Sur cette figure 1, soit A la diode dans laquelle la pastille de semiconducteur est soudée sur une embase métallique et comporte une connexion supérieure. Soit $\varnothing_i$ diamètre du plot métallique sur lequel est soudée la diode A, $\varnothing_e$ diamètre de l'embase, c'est-à-dire également le diamètre intérieur de la cavité, soit B la distance qui sépare la connexion supérieure de l'embase et C l'épaisseur de la diode, ou encore la distance qui sépare la connexion supérieure du plot sur lequel est soudée la pastille. La pastille de diode est entourée d'un diélectrique de constante donnée, ou de plusieurs diélectriques de constantes différentes qui donnent une constante équivalente moyenne. Selon les cas, le diélectrique qui entoure la pastille est soit de l'air soit un isolant sous forme de résine. On démontre que l'impédance de l'espace entourant la diode ayant une valeur $R_e + jX_e$ ramené à la périphérie, il existe un ensemble unique de valeurs de $\varnothing_i$, $\varnothing_e$, B, C tel qu'il y a adaptation d'impédance du dispositif semiconducteur, soit:

$R_e = k_1R$ et $X_e = k_2X$

Cependant, dans la pratique, il suffit que $k_1R$ et $k_2X$ s'approchent suffisamment de $R_e$ et $X_e$ car

alors les accords mécaniques classiques dans la monture deviennent extrêmement aisés; c'est pourquoi l'on dit préadaptation et non pas adaptation.

Cette transformation d'impédance est extrêmement intéressante en particulier pour les diodes à avalanche, car elle simplifie considérablement la cavité: par exemple la polarisation sur l'électrode supérieure peut être réalisée par un simple fil fin. En outre, et ceci est montré sur la figure 2, la courbe de la puissance délivrée en fonction d'une autre variable telle que le courant de polarisation 1 ou la température ambiante T, est très propre et sans hystérésis, ou sans accroc. Ainsi sur la figure 2, la courbe 1 représente la courbe de puissance de diodes encapsulées dans un boîtier sans adaptation d'impédance: cette courbe ne connaît pas une variation régulière, mais au contraire présente des décrochages, ceux-ci variant de plus d'une diode à l'autre selon le boîtier. Au contraire la courbe 2 qui présente une variation très régulière correspond à une diode correctement encapsulée dans un boîtier avec adaptation d'impédance.

Ceci montre l'importance qu'il y a, surtout à de telles fréquences proches de 100 GHz, à ce qu'une pastille de diode soit correctement encapsulée et montée dans son boîtier, qui fait cavité, tout ceci de préférence à partir de pièces réalisées de façon collective de façon à être plus industriel.

L'invention décrit le montage dans un boîtier d'une pastille de diode réalisée de façon collective, et avec des connexions telle que la transformation radiale d'impédance obtenue atteigne le but fixé à savoir d'un réglage aisé et d'un fonctionnement propre. Ceci est obtenu d'une part au moyen de connexions internes au boitier en forme d'étoile métallique dite faux beam-lead parce que les bandes de métal qui constituent l'étoile ne sont pas planes mais incurvées, l'ensemble de l'étoile formant en son centre entourant la pastille de diodes, cet anneau ayant une épaisseur inférieure à 120 microns. Le procédé de connexion d'une pastille de semiconducteur par poutres métalliques dit beam-lead est en soit connu, mais les poutres sont très généralement planes, c'est le cas du vrai beam-lead, ce qui entraîne un effet de capacité parasite entre la connexion supérieure de la pastille et l'embase sur laquelle celle-ci est montée. Les poutres incurvées qui ne sont pas parallèles à la surface libre de l'embase mais qui au contraire s'en éloignent, ainsi qu'un anneau de quartz d'épaisseur inférieure ou égale à 120 microns, font que la diode est adaptée ou suffisamment adaptée en impédance à son environnement extérieur, et que sa courbe de puissance en fonction d'autres paramètres telle que l'intensité de polarisation ou la température ambiante est très propre et sans accroc. De plus ce type de montage permet un ajustage de la fréquence par légère attaque chimique de la pastille, avant fermeture du boîtier par thermocompression.

De façon plus précise l'invention concerne un module préadapté pour diode hyperfréquence, comportant une pastille de diode fixée à l'intérieur d'un boîtier constitué par une embase métallique formant une première connexion de la diode, un anneau de diélectrique fixé sur l'embase un capot métallique, de fermeture et d'adaptation d'impédance, fixé sur l'anneau et une seconde connexion de la diode, entre la pastille et le capot de fermeture, ce module étant caractérisé en ce que la seconde connexion de la diode est constituée par une étoile métallique, monobloc, préformée en forme de corolle, dont les branches ont une forme incurvée de concavité orientée vers l'embase et formant au centre de l'étoile un tronc de pyramide.

L'invention sera mieux comprise par le description d'un exemple d'application, laquelle s'appuie sur les figures annexées qui représent:

- figure 1: schéma d'adaptation d'impédance d'une diode à l'espace l'entourant.

figure 2: courbe de puissance d'une diode en fonction de sa transformation impédance.

- figure 3: une diode encapsulée et adaptée en impédance selon l'art antérieur.

- figure 4: une diode encapsulée et adaptée en impédance selon l'invention

- figures 5 à 8: étapes de fabrication d'un faux beam-lead.

A partir des raisons fondamentales, exposées en s'appuyant sur les figures 1 et 2, qui montrent l'intérêt de l'adaptation d'impédance d'une diode à son boîtier d'encapsulation, la figure 3 représente un exemple d'application selon l'art antérieur.

Une approche de ces problèmes d'adaptation d'impédance a déjà été faite par la Demanderesse en particulier dans les demandes de brevet FR-A 2 348 574 et FR-A 2 420 208. Ces demandes de brevet décrivent des procédés de montage qui en fait ne sont pas suffisamment industriels pour beaucoup d'applications.

La figure 3 représente une partie d'un boîtier d'encapsulation d'une iode travaillant en hyperfréquence. Sur une embase métallique 3 en cuivre, doré et comportant un picot central, est soudée une pastille de diode 4, sur laquelle a été déposée auparavant une épaisseur d'or 5. Un disque de quartz 6 est collé autour de la pastille de diode 4 sur l'embase 3 et l'espace compris entre la pastille de diode 4 et l'intérieur du disque de quartz 6 est remplie par une résine 7. Puis l'ensemble est rôdé jusqu'à faire réapparaître par amincissement, l'épaisseur d'or 5 qui a été déposée sur la pastille de diode 4. Une connexion supérieure 8, se présentant soit sous la forme d'un disque métallique soit sous la forme d'une étoile métallique dite vrai beam-lead est alors soudée sur l'épaisseur d'or 5, c'est-à-dire en contact avec la diode, et repose à sa périphérie sur la face libre du disque de quartz 6. L'ensemble est ensuite recouvert d'un capot, non représenté sur cette figure ou encapsulé dans une cavité plus complexe si nécessaire.

Ce type de montage selon l'art connu présente plusieurs inconvénients. En premier lieu, la connexion 8 qui est un ruban ou une plaque métallique est parallèle à la face de l'embase sur laquelle est montée la diode et présente ainsi une certaine capacité parasite, non négligeable à la fréquence de travail de la diode. Et surtout en second lieu, ce type d'encapsulation est unitaire, nécessite un rôdage, et la méthode est donc longue, coûteuse et peu industrielle. Enfin la diode est montée sans possibilité de réglage ultérieur, par exemple par amincissement chimique, par une légère attaque acide, puisque la diode est en fait noyée à l'intérieur d'une résine 7 et protégée sur ses deux faces par l'embase de cuivre 3 et par l'épaisseur d'or 5: puisqu'un ajustage n'est pas possible une fois que l'opération d'encapsulation est effectuée, le réglage ou l'adaptation en fréquence n'est pas non plus possible.

C'est pourquoi les diodes hyperfréquences sont également montées de façon connue dans un microboîtier constitué par une embase métallique, qui fait radiateur, un anneau de quartz et un couvercle métallique d'adaptation d'impédance. La liaison électrique entre la pastille de diode, fixée sur l'embase, et le couvercle se fait au moyen d'un ou plusieurs rubans d'or, soudés sur la pastille et sur la tranche métallisée de l'anneau de quartz, donc en contact avec le couvercle.

Un tel montage est représenté par exemple dans les documents "Nachrichten Elektronik", vol 33, n° 4, avril 1979, pages 118, 123, ou dans FR - A - 2 284 195

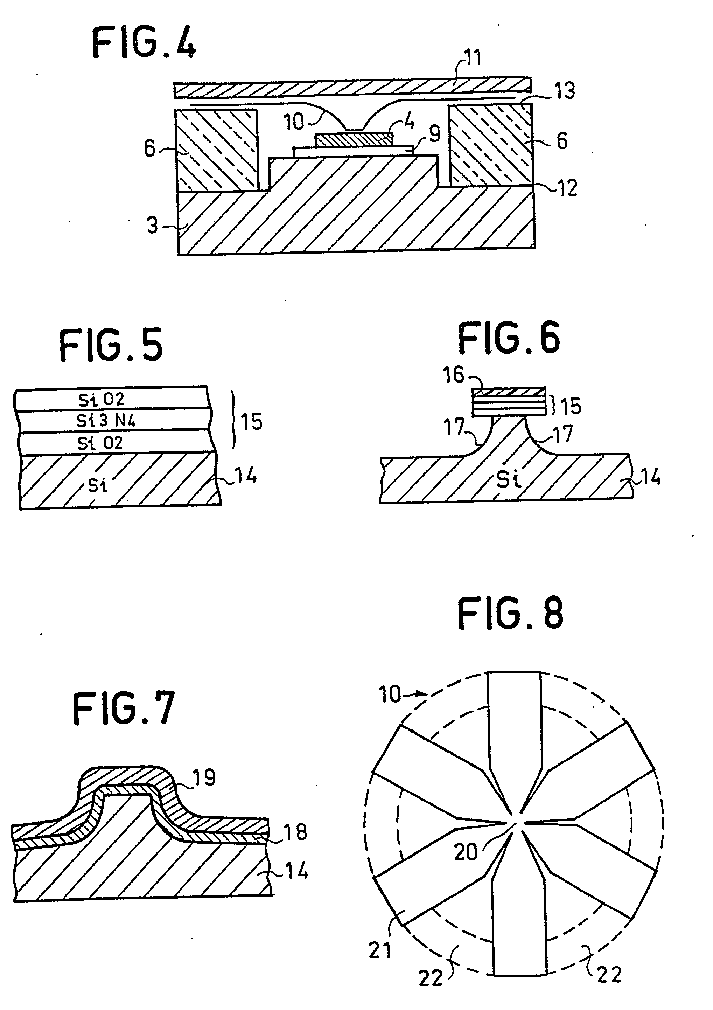

La figure 4 représente une diode encapsulée dans un boîtier selon l'invention, et adaptée ou préadaptée suffisamment en impédance.

La pastille 4 de la diode équipée d'une lamelle d'or 9 servant de radiateur intégré, l'ensemble 4 et 9 étant découpé dans une rondelle qui en contient un très grand nombre, est tout d'abord rapportée sur une embase 3 en cuivre nickelé et doré, généralement par brasure ou par thermocompression de la lamelle 9. Un anneau de quartz 6 est thermo-comprimé, collé ou soudé sur l'embase 3 au niveau du joint 12, puis la connexion supérieure 10 en forme de faux beam-lead est rapportée sur la pastille de la diode: elle s'appuie sur la face supérieure 13 de l'anneau de quartz 6, et l'ensemble est refermé par un couvercle métallique 11 lui aussi thermo-comprimé, collé ou brasé sur la face supérieure de l'anneau de quartz.

La connexion 10 de la diode est, comme cela a déjà été dit, en forme d'étoile métallique dont les branches ne sont pas planes, mais s'éloignent de l'embase 3, ce qui diminue l'inductance et la capacité parasites. Le fait que la connexion de polarisation 10 se présente sous la forme d'une étoile permet, lorsque la diode a été fixée sur l'embase et avant que le couvercle 11 ne soit rapporté, de procéder à un réglage de fréquence d'oscillation du dispositif au moyen d'une légère attaque chimique, qui permet de réduire le diamètre de la pastille de diode, l'introduction du liquide réactif étant possible puisque la connexion 10 présente des orifices entre les bras de l'étoile.

La réalisation de ce type de montage présente peu de difficultés malgré les dimensions très petites de l'ensemble. A titre d'illustration, non limitative de l'invention, après découpe dans une rondelle, une pastille de semi-conducteur telle qu'une diode hyperfréquence Impatt devant fonctionner à 94 GHz a un diamètre de 35 microns, une épaisseur de 5 microns et se trouve thermocomprimée sur une pièce d'or 9, de 200 microns de côté et de 50 microns d'épaisseur. L'anneau de quartz 6, métallisé sur ses deux faces 12 et 13, a un diamètre extérieur compris entre 750 et 800 microns, un diamètre intérieur compris entre 400 et 450 microns, et une épaisseur de ordre de 100 microns si l'embase de cuivre 3 est plane, ou de l'ordre de 150 microns si l'embase 3 comporte un plot sur lequel est fixée la diode. Ces dimensions sont citées afin de mettre en évidence la difficulté qu'il y a à réaliser une étoile métallique qui ne soit pas plane: sa fabrication échappe aux techniques connues de la métallurgie et est expliquée au moyen des figures 5 à 8.

Pour réaliser une étoile en faux beam-lead, telle que la connexion 10 de la figure 4 il est nécessaire de réaliser d'abord une matrice à partir d'une tranche de silicium - figure 5 - sur laquelle sont déposées successivement une couche de silice Si $O_2$ de 0,2 micron d'épaisseur, une couche de nitrure de silicium $Si_3N_4$ de 0,15 micron d'épaisseur et une couche de silice Si $O_2$ de 0,2 micron d'épaisseur. La figure 6 représente l'étape suivante de réalisation du faux beam-lead. Sur la précédente tranche de silicium 14 recouverte par ces trois couches de protection 15, on définit par photomasquage des zones 16, puis on attaque chimiquement les couches de protection 15 jusqu'à mettre à nu la tranche de silicium 14. En poursuivant l'attaque chimique, le silicium est à son tour attaqué et comme l'attaque chimique se prolonge sous les couches de protection 15, on obtient à l'issue de cette opération un mésa dont les deux flancs 17 ont une forme légèrement arrondie, qui donne ainsi une forme en corolle.

L'ensemble des couches de protection 15 et de la couche de résine de photomasquage 16 sont alors supprimées.

Après élimination de ces couches de protection, on réalise - figure 7-un dépôt 18 de chrometor sur le mésa ainsi formé. Puis après photomasquage pour obtenir la forme d'étoile désirée, on effectue une croissance électrolytique d'or 19, d'une épaisseur de 2 microns, ce qui permet de former les connexions en forme de faux beam-lead à plusieurs branches.

La dernière opération pour récupérer des pièces 10 ayant une forme évasée et un dessin d'étoile consiste à attaquer chimiquement le chrome or/18 non masqué et ce qui reste du silicium 14 qui a initialement servi à former un mésa.

La figure 8 représente une telle connexion, et met en évidence la forme d'étoile qui n'apparaît pas sur la figure 7. La partie centrale 20 de ce faux beam-lead est celle qui est thermocomprimée sur la pastille de diode, tandis que l'extrémité de chaque branche 21 est celle qui est thermocomprimée sur la face métallisée 13 du disque de quartz 6.

L'étoile de la figure 8 est représentée avec 6 branches, et le nombre de branches n'est pas déterminatif de l'invention, puisque ce qui est important est de réaliser une connexion métallique qui ne soit pas plane de façon à s'éloigner du substrat, et qui permette à un liquide tel qu'un acide de circuler entre les branches d'étoile de façon à pouvoir attaquer chimiquement la pastille semiconductrice. De plus, sur la figure 8 est représentée une forme particulièrement bien adaptée de beam-lead évasé, c'est-à-dire que chaque branche d'étoile devient de plus en plus large au fur et à mesure que l'on se rapproche du contour extérieur du boîtier d'encapsulation: cette solution permet de diminuer la self de la connexion. Cependant d'autres dessins d'étoile avec des branches constituées par des bandes dont les côtés sont ou non parallèles entre eux, ou avec un nombre de branches différent entrent dans le domaine de l'invention.

A titre d'exemple, et sans que ceci soit limitatif de l'invention, mais plutôt pour montrer la difficulté qu'il y aurait à façonner une telle pièce par d'autres procédés métallurgiques, le faux beam-lead de la figure 8 a de l'ordre de 720 microns de diamètre; chacune de ces branches a 230 microns de longueur sur 120 microns de largeur dans sa partie rectangulaire et le coeur 20 de cette étoile métallique à 50 microns de côté: il n'est pas possible de réaliser une telle pièce par exemple par emboutissage d'une feuille d'or.

Lorsque cette connexion en forme de faux beam-lead est fixée par thermocompression sur la pastille semiconductrice 4 de la figure 4, il est possible de tester les pastilles en fréquence avant de refermer le boîtier par un couvercle 11 de cuivre nickelé et doré. Si la fréquence n'est pas exactement celle qui est désirée, et compte-tenu du diamètre du capot 11 qui fixe la fréquence d'oscillation du module préaccordé, en contribuant à la tranformation radiale d'impédance, il est alors possible d'effectuer une légère attaque chimique de la pastille 4 par introduction d'acide entre les branches de l'étoile de faux beam-lead 10 et rinçage. La fréquence étant ajustée au mieux le couvercle 11 est rapporté sur la rondelle de quartz 6 et l'encapsulation est achevée et étanche.

Eventuellement, et dans le but d'assurer une parfaite étanchéité entre la rondelle de quartz 6 et le capot 11, la connexion en faux beam-lead 10 comporte, venant de fabrication, un joint 22 qui réunit entre elle les différentes branches 21 du faux beam-lead. Ce joint permet lorsque le boîtier a été fermé par thermocompression d'assurer plus facilement une étanchéité parfaite entre les branches du faux beam-lead, et par conséquent l'absence de toutes fuites au niveau du couvercle 11.

Le procédé de montage de diode hyperfréquence selon l'invention permet donc d'obtenir un semiconducteur, ajustable en fréquence par un procédé chimique, car il n'est pas enrobé par un polymère ou une résine, et dont la transformation radiale d'impédance est effectuée par les dimensions mêmes du boîtier, celui-ci pouvant être thermocomprimé, et non pas collé comme cela se fait généralement. Cette invention est précisée par les revendications ci-après.

## Revendications

1. Module préadapté pour diode hyperfréquence, comportant une pastille de diode (4) fixée à l'intérieur d'un boîtier constitué par une embase métallique (3) formant une première connexion de la diode, un anneau de diélectrique (6) fixé sur l'embase (3), un capot (11) métallique, de fermeture et d'adaptation d'impédance, fixé sur l'anneau (6), et une seconde connexion de la diode (4), entre la pastille et le capot (11) de fermeture, ce module étant caractérisé en ce que la seconde connexion de la diode (4) est constituée par une étoile métallique (10), monobloc, préformée en forme de corolle, dont les branches (21) ont une forme incurvée de concavité orientée vers l'embase (3) et formant au centre de l'étoile (10) un tronc de pyramide.

2. Module préadapté selon la revendication 1, caractérisé en ce que le centre de l'étoile métallique (10) est en contact électrique avec la pastille de diode (4) et les extrémités des branches (21) de l'étoile (10) en contact électrique avec le capot de fermeture (11), par lequel est amenée la tension de polarisation.

3. Module préadapté selon la revendication 1, caractérisé en ce que les branches (21) de l'étoile (10) ont des côtés qui ne sont pas parallèles entre eux, plus larges sur le contour extérieur de l'étoile quen son centre (20).

4. Module préadapté selon la revendication 1, caractérisé en ce que l'étoile (10) comporte, sur son pourtour, une bande circulaire (22), réunissant les extrêmités des branches (21) et formant joint entre l'anneau diélectrique (6) et le capot (11) de fermeture.

5. Module préadapté selon la revendication 1, caractérisé en ce que l'étoile (10) comprend une couche de chrome-or (18) renforcée par une couche d'or (19).

## Patentansprüche

1. Vorangepaßter Modul für Mikrowellendiode, versehen mit einem Diodenplättchen (4), das innerhalb eines Gehäuses befestigt ist, das durch einen einen ersten Diodenanschluß bildenden Metallsockel (3) gebildet ist, mit einem auf dem Sockel (3) befestigten dielektrischen Ring (6), einer metallischen Haube (11) zum Verschließen und zur Impedanzanpassung, welche auf dem Ring (6) befestigt ist, und mit einem zweiten Diodenanschluß (4) zwischen dem Plättchen und der Verschlußhaube (11), wobei dieser Modul dadurch gekennzeichnet ist, daß der zweite Diodenanschluß (4) durch einen metallischen, einen einzigen Block bildenden Stern (10) gebildet ist, welcher als Strahlenkranz vorgeformt ist, dessen Strahlen (21) eine einwärtsgekrümmte Form aufweisen, deren konkave Seite zu dem Sockel (3) hin orientiert ist, und der in der Mitte des Sterns (10) einen Pyramidenstumpf bildet.

2. Vorangepaßter Modul nach Anspruch 1, dadurch gekennzeichnet, daß der Mittelpunkt des metallischen Sterns (10) in elektrischem Kontakt mit dem Diodenplättchen (4) steht und die Enden der Strahlen (21) des Sterns (10) in elektrischem Kontakt mit der Verschlußhaube (11) stehen, über welche die Polarisationsspannung zugeführt wird.

3. Vorangepaßter Modul nach Anspruch 1, dadurch gekennzeichnet, daß die Strahlen (21) des Sterns (10) Seiten aufweisen, die zueinander nicht parallel sind, und an der Außenkontur des Sterns breiter als in seiner Mitte (20) sind.

4. Vorangepaßter Modul nach Anspruch 1, dadurch gekennzeichnet, daß der Stern (10) an seinem Umfang ein kreisrundes Band (22) aufweist, welches die Enden der Strahlen (21) verbindet und eine Vereinigung zwischen dem dielektrischen Ring (6) und der Verschlußhaube (11) herstellt.

5. Vorangepaßter Modul nach Anspruch 1, dadurch gekennzeichnet, daß der Stern (10) eine Chrom-Gold-Schicht (18) aufweist, die durch eine Goldschicht (19) verstärkt ist.

## Claims

1. Preadapted module for a microwave diode comprising a diode wafer (4) fixed in the interior of a housing formed by a metal base (3) forming a first diode connection, a dielectric ring (6) secured to the base (3), a metallic hood (11) for closure and impedance adaptation fixed on the ring (6), and a second diode connection (4) between the wafer and the closure hood (11), said module being characterized in that the second diode connection (4) is formed by a metallic monoblock star (10) having the form of a corolla whose branches (21) have an inwardly curved form concave towards the base (3), and forming at the centre of the star (10) a pyramid trunk.

2. Preadapted module according to claim 1, characterized in that the centre point of the metallic star (10) is in electrical contact with the diode wafer (4) and the ends of the branches (21) of the star (10) are in electrical contact with the closure hood (11) via which the polarization voltage is applied.

3. Preadapted module according to claim 1, characterized in that the branches (21) of the star (10) have sides which are not parallel to each other, wider at the outer contour of the star than in the centre (20) thereof.

4. Preadapted module according to claim 1, characterized in that the star (10) comprises at its periphery a circular strip (21) which connects the ends of the branches (21) together and establishes a joint between the dielectric ring (6) and the closure hood (11).

5. Preadapted module according to claim 1, characterized in that the star (10) has a chromium-gold layer (18) which is reinforced by a gold layer (19).

# FIG.1

# FIG.2

# FIG.3

# FIG.4

# FIG.5

# FIG.6

# FIG.7

# FIG.8